(19) Europäisches Patentamt / European Patent Office / Office européen des brevets

(11) **EP 1 943 684 B1**

(12) **EUROPÄISCHE PATENTSCHRIFT**

(45) Veröffentlichungstag und Bekanntmachung des Hinweises auf die Patenterteilung:
**07.12.2016 Patentblatt 2016/49**

(21) Anmeldenummer: **06805465.9**

(22) Anmeldetag: **18.10.2006**

(51) Int Cl.:
*H01L 31/02* *(2006.01)*       *H01L 31/102* *(2006.01)*
*H01L 31/105* *(2006.01)*       *H01L 31/108* *(2006.01)*

(86) Internationale Anmeldenummer:
**PCT/DE2006/001866**

(87) Internationale Veröffentlichungsnummer:
**WO 2007/045232 (26.04.2007 Gazette 2007/17)**

(54) **Verfahren zum Optimieren eines monolithischen Photodioden-Chips**

Process of optimisation of a monolithic photodiode chip

Procédé d'optimisation d'une puce monolithique comprenant une photodiode

(84) Benannte Vertragsstaaten:
**DE FR GB**

(30) Priorität: **21.10.2005 DE 102005051571**

(43) Veröffentlichungstag der Anmeldung:
**16.07.2008 Patentblatt 2008/29**

(60) Teilanmeldung:
**11075031.2 / 2 323 177**

(73) Patentinhaber: **Fraunhofer-Gesellschaft zur Förderung der angewandten Forschung e.V.
80686 München (DE)**

(72) Erfinder:
• **BACH, Heinz-Gunter
14163 Berlin (DE)**
• **BELING, Andreas
Charlottesville, VA 22903 (US)**

(74) Vertreter: **Pfenning, Meinig & Partner mbB
Patent- und Rechtsanwälte
Joachimsthaler Straße 12
10719 Berlin (DE)**

(56) Entgegenhaltungen:
EP-A- 0 367 680       WO-A-94/06223
DE-A1- 10 215 414       US-A- 5 461 246

• WEN-JENG HO ET AL: "InGaAs PIN photodiodes on semi-insulating InP substrates with bandwidth exceeding 14 GHz" SOLID STATE ELECTRONICS, ELSEVIER SCIENCE PUBLISHERS, BARKING, GB, Bd. 38, Nr. 7, Juli 1995 (1995-07), Seiten 1295-1298, XP004011815 ISSN: 0038-1101
• CHARLES L GOLDSMITH ET AL: "Principles and Performance of Traveling-Wave Photodetector Arrays" IEEE TRANSACTIONS ON MICROWAVE THEORY AND TECHNIQUES, IEEE SERVICE CENTER, PISCATAWAY, NJ, US, Bd. 45, Nr. 8, August 1997 (1997-08), XP011036903 ISSN: 0018-9480
• LEWÉN R ET AL: "Design of Inductive p-i-n Diode Matching for Optical Receivers With Increased Bit-Rate Operation" JOURNAL OF LIGHTWAVE TECHNOLOGY, XX, XX, Bd. 19, Nr. 12, Dezember 2001 (2001-12), XP011030087 ISSN: 0733-8724
• BELING A ET AL: "InP-based 1.55 [mu]m high-speed photodetectors for 80 Gbit/s systems and beyond" PROCEEDINGS OF 2005 7TH INTERNATIONAL CONFERENCE ON TRANSPARENT OPTICAL NETWORKS 3-7 JULY 2005 BARCELONA, CATALONIA, SPAIN, Juli 2005 (2005-07), Seiten 303-308, XP002431396 Piscataway, NJ, USA
• WHEELER H A: "Transmission-line properties of a strip on a dielectric sheet on a plane" IEEE TRANSACTIONS ON MICROWAVE THEORY AND TECHNIQUES, Bd. MTT-25, Nr. 8, August 1977 (1977-08), Seiten 631-647, XP002431397

EP 1 943 684 B1

- **BACH H-G ET AL: "InP-Based Waveguide-Integrated Photodetector With 100-GHz Bandwidth", IEEE JOURNAL OF SELECTED TOPICS IN QUANTUM ELECTRONICS, IEEE SERVICE CENTER, PISCATAWAY, NJ, US, vol. 10, no. 4, July 2004 (2004-07), pages 668-672, XP011120254, ISSN: 1077-260X, DOI: 10.1109/JSTQE.2004.831510**
- **UNTERBOERSCH G ET AL: "HIGH-BANDWIDTH 1.55 MUM WAVEGUIDE INTEGRATED PHOTODETECTOR", PROCEEDINGS OF THE EIGHTH INTERNATIONAL CONFERENCE ON INDIUM PHOSPHIDE AND RELATED MATERIALS 1996. SCHWABISCH GMUND, APR. 21 - 25, 1996; [PROCEEDINGS OF THE INTERNATIONAL CONFERENCE ON INDIUM PHOSPHIDE AND RELATED MATERIALS (IPRM)], NEW YORK, IEEE, U, vol. CONF. 8, 21 April 1996 (1996-04-21), pages 203-206, XP000634466, ISBN: 978-0-7803-3284-3**

**Beschreibung**

Die Erfindung betrifft ein Verfahren zum Optimieren eines monolithischen Photodioden-Chips für dessen Herstellung. Der Photodioden-Chip ist mit einem Leitungsübergang vom aktiven Photodiodenbereich eines Photodioden-Mesas zum Ausgangs-Pad eines Hochfrequenzausgangs des Photodioden-Chips versehen. Dabei kann auf dem Chip vorteilhaft, aber nicht notwendigerweise, eine Abschlussimpedanz mit integriert sein.

Für Ultrabreitband-Photodioden ist das Quantenwirkungsgrad-Bandbreiteprodukt ein wesentliches Qualitätsmerkmal, welches für Frequenzen oberhalb von 40 GHz in der Regel nur durch Kompromisse im Design (Quantenwirkungsgrad vs. Transitzeitlimitierung vs. RC-Limitierung) entworfen werden kann. Dieser Designkompromiss wird bei fortgeschrittenen integrierten Bauformen von Zweidioden-Detektoren (Balanced Detektor) besonders kritisch, da hier durch die Parallelschaltung zweier Photodioden eine verdoppelte Kapazität in die RC-Limitation eingeht.

Bisher wurde der bei Photodioden bekannte Kompromiss zwischen Transitzeit begrenzter Bandbreite und Absorptions-Quantenwirkungsgrad bei den immer höher benötigten Betriebsgrenzfrequenzen (10 GHz hin zu 50 GHz) dadurch gelöst, dass von der Bauform der senkrecht beleuchteten Photodiode zur seitlich beleuchteten Photodiode übergegangen wurde. Derartige Photodioden sind zum Beispiel aus DE 100 44 521 A1 bekannt. Damit konnte bei Einzelphotodioden der Frequenzbereich von bisher 15 GHz hin zu typisch 65 GHz bei möglichst hoch zu erhaltender Responsivität um 0,7 A/W erschlossen werden. Oberhalb von 65 GHz ist auch beim seitlich beleuchteten Photodiodenkonzept, sowohl in den Unterbauformen der Wellenleiterphotodiode wie der evaneszent beleuchten Photodiode erneut ein kritischer Kompromiss zwischen Wirkungsgrad und Bandbreite einzugehen, so dass Bedarf bestand, beim Bandbreitefaktor nach weiteren Steigerungen zu suchen.

Die hier betrachteten Photodioden sind mit einer integrierten Lastimpedanz abgeschlossen, zum Beispiel 50 Ohm, nach außen parallel beschaltet, womit die Signalintegrität deutlich verbessert wird. Dies basiert am Ort der Photodiode auf der Unterdrückung von Reflexionen, die zuvor von einer Folgeelektronik zur Photodiode reflektiert werden konnten.

In der Literatur ist die Anhebung der Bandbreite bei Photodioden durch das sog. "induktive Peaking" wohlbekannt, siehe Kato et al., Design of Ultrawide-Band, High-Sensivity p-i-n Photodetectors, IEICE Trans. Electron. Vol. E76-C, No. 2, Febr. 1993, S. 214-221. Hierbei wird der kapazitiven Stromquelle (pn-Übergang der Photodiode) eine kleine Induktivität in Serie geschaltet (typischerweise ein Bonddraht). Wenn diese Ersatzschaltung ihre elektrische Energie in einen ohmschen Lastwiderstand einspeist, kann die RC-Bandbreite, die ohne die Induktivität durch $1/2\pi R_{ges}C_{ges}$ gegeben war, gegenüber diesem RC-Limit um bis zu einem Faktor von ca. $\sqrt{2}$ erhöht werden (Serienresonanzeffekt). Der Nachteil dieser Methode ist, dass die gewünschte Bandbreitenerhöhung mit einer stark nichtlinearen Phasendrehung über der Frequenz, insbesondere in der Nähe der oberen Grenzfrequenz, erkauft wird.

Aus der Veröffentlichung Bach H-G et al. "InP-Based Waveguide -Integrated Photodetector With 100-GHz Bandwidth", IEEE Journal of Selected Topics in Quantum Electronics, IEEE Service Center, Piscataway, NJ, US, Bd. 10, Nr. 4, 1. Juli 2004, Seiten 668-672, XP 011120254, ISSN: 1077-260X ist ein wellenleiterintegrierter Photodetektor mit 100 GHz Bandbreite bekannt, bei dem das p-i-n Dioden Ersatzschaltbild, ein Abschlusswiderstand, ein koplanarer Leitungstaper und die mit einer Luftbrücke verbundene p-i-n Heterostrukturphotodiode beschrieben und simuliert wurden und wobei eine p-Zinkdiffusion für einen niederohmigen p Kontakt in Hinblick auf eine effektive Absorptionsschichtdicke berücksichtigt wurde. Auf die Impedanzkontrolle durch die Luftbrücke wird in dieser Veröffentlichung hingewiesen.

Aufgabe der Erfindung ist es, ein Verfahren zur Optimierung einer passiven Photodioden-Beschaltung anzugeben, deren Bandbreite bei Einfachdioden auf über 100 GHz gesteigert werden kann, ohne dass die Responsivität sinkt, das heißt ohne eine Flächen- oder Längenverringerung der Photodiode in Kauf zu nehmen. Ziel der Erfindung ist dabei nicht nur die Kontrolle des Frequenzgangs eines alleinigen Photodiodenchips, sondern auch die reproduzierbare Einstellung des Frequenzgangs eines Detektormoduls, welches einen monolithischen Photodiodenchip als Hauptbestandteil enthält.

Erfindungsgemäß wird die Aufgabe gelöst durch die Merkmale des Anspruchs 1. Zweckmäßige Ausgestaltungen sind Gegenstand des Unteranspruchs 2.

Die Verbindung vom Photodioden-Mesa zum Ausgangs-Pad ist mit einer hochohmigen Leitung mit einer über deren Länge verteilter Impedanz realisiert, die mindestens so hoch ist wie die effektive Lastimpedanz. Die effektive Lastimpedanz ist beispielsweise die am Chipausgang seitens der Photodiode gesehene Parallelschaltung aus der chip-externen Lastimpedanz (50 Ohm) und der oft on-chip mitintegrierten Lastimpedanz (damit ebenfalls 50 Ohm).

In erfindungsgemäß bevorzugter Weise ist die Impedanz der hochohmigen Leitung mindestens doppelt so hoch wie die effektive Lastimpedanz.

Die Bandbreite wird dadurch gesteigert, dass bei den beiden bandbreiten-begrenzenden Einflüssen Transitzeitlimitation und RC-Limitation die RC-Limitation durch eine impedanzkontrollierte Leitungsführung vom pin-Mesa der Diode hin zum gegebenenfalls widerstandsbelasteten Ausgangs-Pad kontrolliert angehoben wird, so dass die resultierende Gesamtbandbreite nun durch die physikalisch limitierende Transitzeitlimitation dominiert wird. Dabei wird auf die Erhaltung einer kurzen, überschwingungsarmen Pulsantwort Wert gelegt, die für die digitalen Signalformen der nachrichtentechnischen Anwendungen wichtig ist.

Grundgedanke ist es, die gewünschte Amplitudenanhebung über einen größeren Frequenzbereich moderat zu verteilen, um die nichtlineare Phasendrehung über größere Frequenzbereiche zu verschmieren und somit auch die für das Pulsverhalten relevante Gruppenlaufzeitstreuung nicht unmäßig zu erhöhen, wie es bei einem Ansatz mittels eines diskreten RLC-Serienschwingkreises leicht der Fall ist.

Die Erfindung setzt daher auch beim Grundmechanismus des induktiven Peakings an, realisiert aber die frequenzgangsanhebende serielle Induktivität nicht als diskretes Element, sondern benutzt eine, im Vergleich zur Lastimpedanz (üblich sind 50 Ohm) hochohmige Leitung mit zum Beispiel 100...150 Ohm Wellenwiderstand.

Untersuchungen im Schaltungssimulator ergaben, dass der gewünschte pegelanhebende Effekt im Frequenzbereich der RC-Limitation auftritt; jedoch fällt ein mögliches Überschwingen im Frequenzbereich des Amplitudenganges verschliffener und moderater aus, so dass auch die Gruppenlaufzeitschwankung geringer ausfallen kann.

Die praktische Realisierung der Erfindung wird bei monolithisch integrierten Photodioden mit sehr hoher Grenzfrequenz (40 GHz und höher) dadurch begünstigt, dass die Leitungsführung auf einem Chip, herunter vom pn-Mesa hin zum Ausgangs-Pad, nicht mehr durch diskrete induktive Elemente, sondern durch verteilte Leitungselemente vorgenommen wird. Selbst kurze Luftbrücken einiger 10 $\mu$m Länge vom pn-Mesa herunter auf die Metallebene besitzen verteilte Streukapazitätselemente einiger fF zum Substrat hin, so dass derartige Luftbrücken als hochohmige Leitungen (Z=$\sqrt{L/C}$) beschrieben werden müssen und nicht mehr durch diskrete Induktivitäten. Eine L-C-verteilte Leitung kann somit in der einfachsten und elegantesten Form durch eine Verlängerung der Luftbrücke über das technologisch nötige Mindestmaß hinaus gebildet werden und in Fällen von zum Beispiel Zweidioden-Empfängern, bei denen beide Dioden nach Zusammenführung ihrer Elektroden vom Pegel-anhebenden Effekt profitieren sollen, durch eine nicht von den Ansprüchen umfaßte dingliche Mikrostreifen- oder Koplanarleitung geeigneter hochohmiger Impedanz realisiert werden.

Das Problem besteht darin, zwar eine nennenswerte Frequenzgangverlaufsanhebung zu erzielen, ohne jedoch die Pulsantwort durch zuviel Überschwingen unangemessen zu benachteiligen. Dies wird durch den verteilten Leitungsansatz im Vergleich zur diskreten Realisierung (eines einzelnen Induktivitätswerts) ermöglicht, weil hier zwei Optimierungsparameter (Impedanz und Leitungslänge) zur Verfügung stehen. Dabei ist das Ausmaß der Frequenzgangsanhebung sorgsam an die beiden, am Photodiodenchip wirksamen Mechanismen anzupassen: die RC-Limitation (der gesamten Umfeldbeschaltung) und die Transitzeitlimitation (im pn-Mesa).

Die Transitzeit-Limitation gibt die letztlich höchstmögliche Bandbreite an, die überhaupt erzielt werden kann, wenn die RC-Limitation durch beliebige Flächenverkleinerung gegen quasi unendlich hochgesetzt würde. Eine Frequenzgangsanhebung über die äquivalente Transitzeit-Grenzfrequenz ist daher zu vermeiden. Wohl aber kann sinnvoll der aus beiden Grenzeinflüssen resultierende Gesamtfrequenzgang an das Transitlimit herangeführt werden, so dass das RC-Limit praktisch weitgehend aufgehoben wird. Geschieht dies mit der erfindungsgemäßen frequenzband-verschmierenden Methode durch verteilte Elemente, kann weiterhin mit einem guten Impulsverhalten gerechnet werden.

Der hier beschriebene und erprobte Mechanismus ist sowohl auf seitlich beleuchtete Photodioden als auch auf alle Bauformen diskreter Photodioden mit senkrechter Beleuchtung anwendbar. Dabei kann die Photodiode wahlfrei vom pn/pin-Typ oder vom MSM (metal-semiconductor-metal)-Typ aufgebaut sein.

Die Erfindung soll nachstehend anhand eines Beispiels einer wellenleiter-integrierten Photodiode näher erläutert werden. In den zugehörigen Zeichnungen zeigen:

Fig. 1     eine Photodiode schematisch in einem Querschnitt,

Fig. 2     das elektrische Ersatzschaltbild der Photodiode mit ihrer Umfeldbeschaltung:

       a) konventionelles induktives Peaking
       b) erfindungsgemäße Frequenzgangsanhebung und Kontrolle mittels einer kurzen hochohmigen Leitung,

Fig. 3     den simulierten Frequenzgang (a), die Gruppenlaufzeit (b) und Pulsantwort (c) einer pin-Photodiode gemäß Fig. 2b) bei Variation der Luftbrückenleitungslänge,

Fig. 4     den gemessenen Frequenzgang der optoelektronischen Leistungskonversion eines wellenleiter-integrierten Photodioden-Chips der nominellen Abmessungen 5 x 20 $\mu$m$^2$,

Fig. 5     einen Balanced Photodiodenchip mit 70 GHz Bandbreite (Layout)

Fig. 6     die optoelektrischen Leistungsfrequenzgänge eines Balanced Photodetektor-Chips mit einem elektrischen Leiterbahn-Layout kontrollierter Impedanz mittels nicht unter die Ansprüche fallender hochohmiger Koplanarleitung,

Fig. 7     ein elektrisches Augendiagramm für ein Detektormodul gemäß Fig. 1 bei 80 Gbit/s und

Fig. 8     ein elektrisches Augendiagramm für ein Detektormodul gemäß Fig. 1 bei 100 Gbit/s.

Die Photodiode ist auf einem InP-Substrat 1 epitaktisch aufgebaut und besteht bei diesem Beispiel aus einem Zuführungswellenleiter 2 und einem Photodioden-pin-Mesa auf Basis von InGaAs/InGaAsP, bestehend aus einer leitfähigen n-Kontaktschicht 3, einer Absorberschicht 4 und einer p-Kontaktschicht 5. Die Absorberschicht 4 des Photodioden-Mesas 4 hat eine Grundfläche von 5 x 20 $\mu m^2$. Die Dicke der Absorberschicht 4 liegt in der Größenordnung von 350 nm. Der Zuführungswellenleiter 2 ist ein Rippenleiter von 2 $\mu m$ Breite.

Die leitfähige n- Kontaktschicht 3 befindet sich zwischen dem Zuführungswellenleiter 2 und der Absorberschicht 4. Die n-Kontaktschicht 3 ist in Richtung des Zuführungswellenleiters 2 um einige $\mu m$ (L) verlängert. In der p-Kontaktschicht 5 sind mehrere p-leitende Heterostrukturschichten inklusive der p-Metall-Kontaktschicht zusammengefasst. Die pin-Photodiode wird demgemäß zwischen der p-Kontaktschicht 5 und der n-Kontaktschicht 3 nach außen angeschlossen.

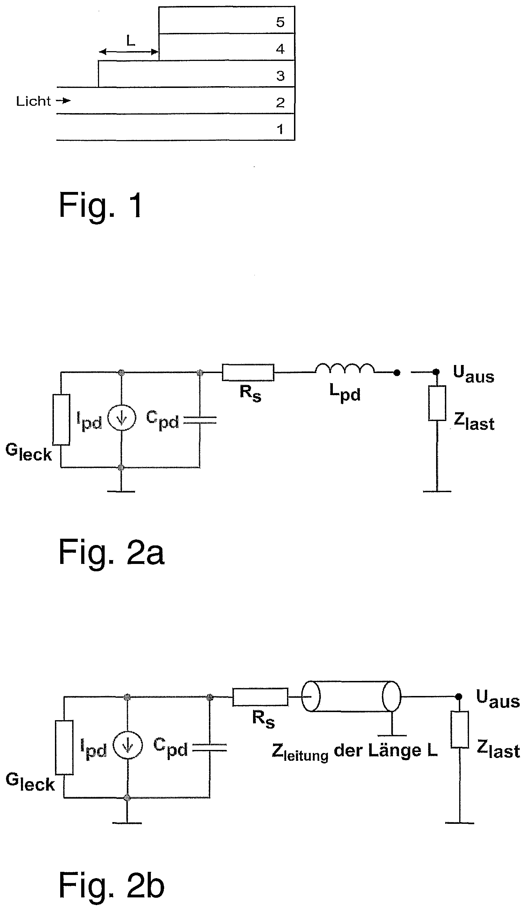

Fig. 2a zeigt das Ersatzschaltbild einer Photodiode ($C_{pd}$, $I_{pd}$, $G_{leck}$, $R_s$) mit dem bekannten induktiven Peaking mittels einer konzentrierten seriellen Induktivität $L_{pd}$, die das Photodiodensignal in eine Lastimpedanz $Z_{last}$ einspeist. Die Lastimpedanz $Z_{fast}$ ist entweder identisch zur externen Last (50 Ohm) oder beinhaltet die zusätzliche Parallelschaltung einer auf dem Chip mitintegrierten Abschlußimpedanz (auch um 50 Ohm). $U_{aus}$ kennzeichnet die Ausgangsspannung am Lastwiderstand.

Fig. 2b zeigt die erfindungsgemäße Umfeldbeschaltung der Photodiode zur kontrolliert gesteuerten Frequenzgangsanhebung mittels einer kurzen hochohmigen Leitung der Impedanz $Z_{leitung}$ und der Länge L. Die Leitung hat eine verteilte Impedanz von ca. 130 Ohm und eine Länge von 70 $\mu m$.

Die Bandbreite wird durch diese Maßnahme gesteigert, indem bei den beiden bandbreiten-begrenzenden Einflüssen: Transitzeitlimitation und RC-Limitation, die RC-Limitation durch die impedanzkontrollierte Leitungsführung vom Photodioden-Mesa der Diode hin zum 50-Ohm-Ausgangspad mittels einer als Leitung wirkenden Luftbrücke, die eine über das technologisch nötige Maß (von ca. 30 $\mu m$) erhöhte Länge besitzt, kontrolliert nach oben angehoben wird, so dass die resultierende Gesamtbandbreite nun durch die physikalisch limitierende Transitzeitlimitation dominiert wird.

Im Ergebnis einer Schaltungssimulation konnte bei Realisierung dieser Maßnahme eine Frequenzganganhebung um ca. 30 - 40 % nachgewiesen werden, bei Erhaltung eines monoton flachen Frequenzganges der Photodiode.

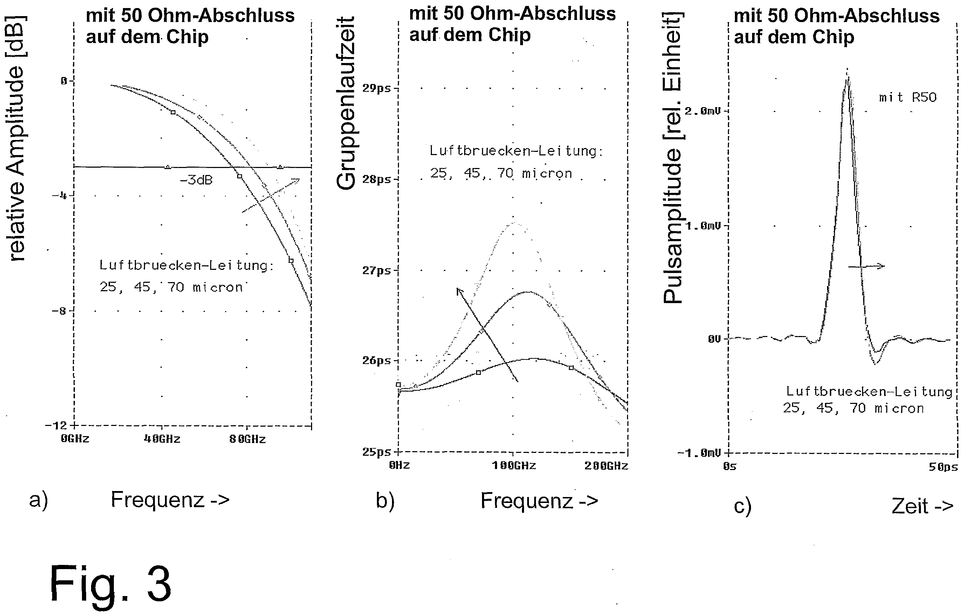

Fig. 3a zeigt den Frequenzgang bei einer Variation der Luftbrückenleitungslänge von 25 $\mu m$ (unterste Kurve) auf 70 $\mu m$ (oberste Kurve). Die hochohmige Leitung wird hierbei neben ihrer kleinen parasitären Streukapazität im fF-Bereich ausgedrückt über ihre äquivalente Längsinduktivität (14 pH - 42 pH).

Bei entsprechend reduziertem Serienwiderstand im 5 Ohm-Bereich ist eine weitere Frequenzganganhebung bis zu einer noch höheren 3 dB-Frequenzgrenze von sogar 100 GHz möglich.

Fig. 3b zeigt zur Veranschaulichung der Maßnahmen die Auswirkung auf die Gruppenlaufzeit, die sich unter 2 ps Streuung hält (also unter 20 % der Bitperiode eines 100 Gbit/s Signals). Fig. 3c zeigt die Pulsantwort des Detektors, wobei das Nachschwingen für die größte Bandbreite unter 15 % des Pulsmaximums bleibt.

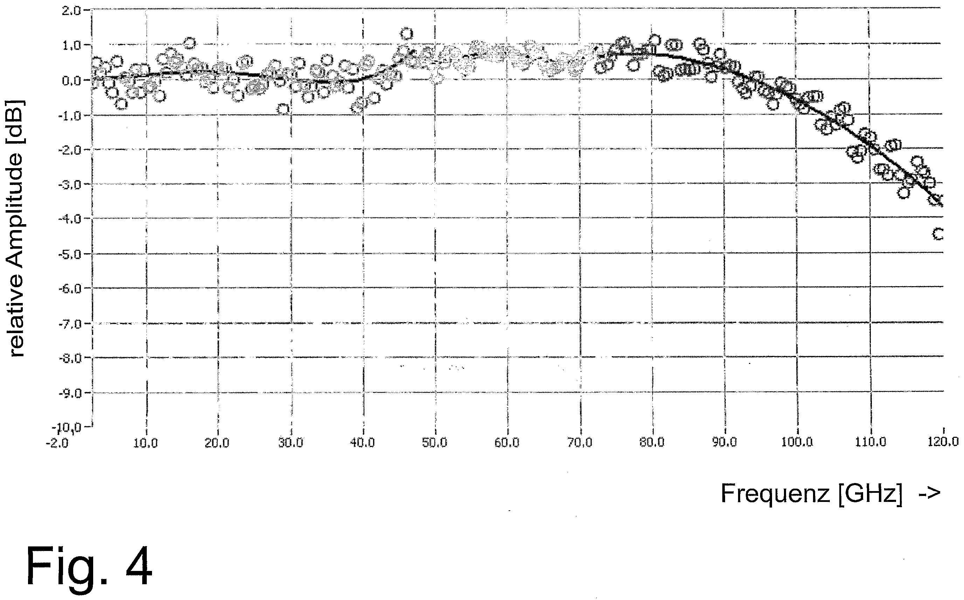

Diese Frequenzganggrenze konnte in der Praxis durch moderates Unterätzen im $\mu m$-Bereich einer nominell 5 x 20 $\mu m^2$ großen Photodiodenfläche sogar bis zu 110 GHz angehoben werden (Fig. 4).

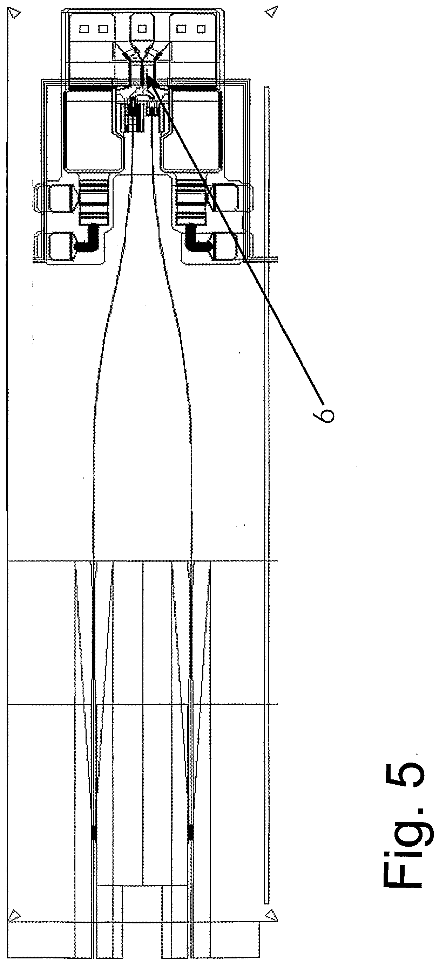

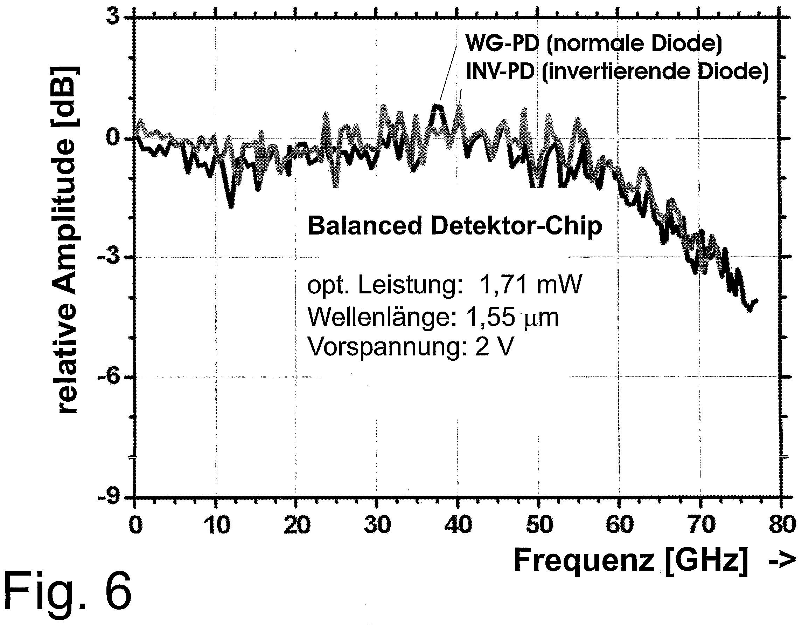

Dasselbe Prinzip, auf die Bauform von Balanced Detektoren (Fig. 5) angewandt, die bislang eine Bandbreite von 40 - 45 GHz aufwiesen, führte nach dem Einbringen der impedanzkontrollierten Leitungsführung vom Vereinigungspunkt beider parallel geschalteter Photodioden bis hin zum 50-Ohm-Abschlusswiderstand über eine nicht unter die Ansprüche fallende hochohmige Koplanarleitung 6 zu einer Steigerung der Bandbreite auf 70 GHz, siehe die Fig. 6.

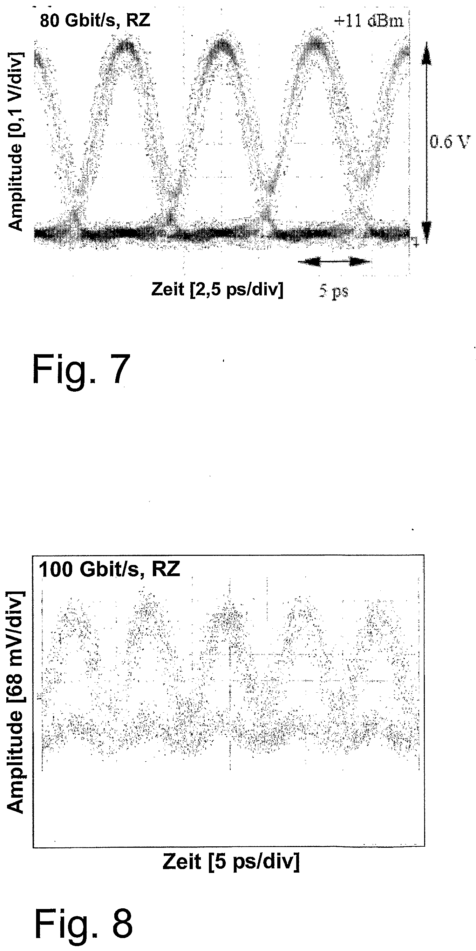

Zum Beleg der ausgezeichneten elektrischen Ausgangspulsformen, die sich unter Anwendung dieses Chip-Designprinzips erzielen lassen, zeigen die Fig. 7 und 8 anhand eines aufgebauten Detektormoduls mit einem Breitbandphotodioden-Chip gemäß Fig. 1 Augendiagramme für das RZ-Modulationsformat, welche bei 80 Gbit/s und 100 Gbit/s aufgenommen wurden. Fig. 7 zeigt ein 80 Gbit/s RZ Augendiagramm bei +11 dBm optischer Eingangsleistung, konvertiert von einem Photodetektormodul unter 2,5 V Sperrspannung: x-Achse: 2.5 ps/div, y-Achse: 100 mV/div, Fig. 8 ein O/Ekonvertiertes 100 Gbit/s RZ-Datensignal mit $2^{20}$-1 PRBS Statistik, detektiert mit einem Photoempfängermodul C05-W16 und einem 100 GHz-Oszilloskop SE100 (LeCroy) bei optischen RZ-Pulsen mit 2,4 ps Pulsbreite; x: 5ps/div, y: 68 mV/div. In beiden Fällen ist eine gute Durchmodulation auf die Null-Linie zu erkennen, die die hohe Bandbreite im 100 GHz-Bereich auch im aufgebauten Modul belegt. Weiterhin sind die auf die "Eins" nachfolgenden Nachschwingeffekte so gering, dass für beide Bitraten weit geöffnete Augen gemessen werden konnten.

Ein Vergleich der RZ-Augendiagramme (Fig. 7, 8) am fertigen Modul mit der Pulsform des Chips in der Fig. 3c zeigt, dass am realen Modul weniger Überschwingen in den Nullen der RZ-Folgen vorliegt, als man vom Pulsbild des Chips erwarten könnte. Dieser günstige Einfluss der Aufbautechnik des Moduls auf die Pulsform ist nicht unerwartet, sondern wurde beim Design des Chips bereits einbezogen. Die im Modul verwendete kurze Verbindungsleitung zwischen Chip und dem 1 mm-Stecker hat ihrerseits eine kleine Dämpfung zwischen 0,5 - 1 dB im Frequenzbereich hin zu 100 GHz. Um diese mit der Frequenz zunehmende Dämpfung vorausschauend mit dem Frequenzgang des Chips auszugleichen, wurde für den Chip mit der erfinderischen Maßnahme ein leicht ansteigender Frequenzgang um 70 GHz herum vorgesehen, wie ihn die Messung in der Fig. 4 zeigt. Zusammen mit der Dämpfung der modulinternen Verbindungsleitung entsteht für das Modul dann ein monoton sanft abfallender Frequenzgangsverlauf, der im Idealfall einem Besselfilter 4. Ordnung ähneln soll, um so für das Gesamtsystem eine möglichst ideale Impulsform bei maximaler Bandbreite zu erzielen. Da die Erfindung die Frequenzgangskontrolle in Form einer monolithischen Integration on-chip vorsieht, ist nur mit geringen Streuungen im fertigen Modulaufbau zu rechnen, da keine kritischen Bonddrahtschleifen mit exakter Höhenkontrolle notwendig sind (wie beim bekannten induktiven Peaking); es wird sogar im Gegenteil im Modulaufbau angestrebt, die Bondverbindungen stets ideal kurz und mittels Mehrfachbondung sehr induktivitätsarm auszuführen, da die gesamte Frequenzgangskontrolle dem monolithischen Chip obliegt, der lithographisch präzise reproduzierbar gefertigt werden kann.

**Patentansprüche**

1. Verfahren zum Optimieren eines monolithischen Photodioden-Chips für dessen Herstellung, bei dem ein Photodioden-Mesa epitaktisch aufgebaut wird und ein Leitungsübergang vom aktiven Photodiodenbereich zum Ausgangs-Pad eines Hochfrequenzausgangs des Photodioden-Chips hergestellt wird, wobei am Ausgangs-Pad eine effektive Lastimpedanz wirkt, die von einer chip-externen Lastimpedanz von 50 Ohm oder einer Parallelschaltung aus der chip-externen und einer on-chip mitintegrierten Lastimpedanz von 50 Ohm gebildet wird, und die Verbindung vom Photodioden-Mesa herunter zum Ausgangs-Pad mit einer hochohmigen Leitung mit über deren Länge verteilter Impedanz √(L/C) realisiert wird, wobei zur Erzielung von Grenzfrequenzen höher als 40 GHz die über die Länge verteilte Impedanz ($Z_{leitung}$) der hochohmigen Leitung durch eine auf dem Photodioden-Chip mitintegrierte streukapazitätsbelastete Luftbrücke mit verteilten Streukapazitätselementen zum Substrat hin realisiert wird und die über die Länge verteilte Impedanz der Luftbrücke mindestens so hoch gewählt wird wie die am Ausgangs-Pad wirksame effektive Lastimpedanz und ihre Länge unter Anhebung der RC-Limitation variiert wird, derart, dass die resultierende -3dB Gesamtbandbreite durch die physikalisch limitierende Transitzeitlimitation dominiert wird.

2. Verfahren zum Optimieren eines Photodioden-Chips nach Anspruch 1, **dadurch gekennzeichnet, dass** die über die Länge verteilte Impedanz ($Z_{leitung}$) der hochohmigen Leitung mindestens doppelt so hoch gewählt wird wie die effektive Lastimpedanz.

**Claims**

1. Method for optimizing a monolithic photodiode chip for its manufacturing, comprising configuring a photodiode mesa epitactically and establishing a transmission line passage from the active photodiode region to an output pad of an high frequency output of the photodiode chip, wherein an effective load-impedance is acting on the output pad, which is represented by a chip-external load impedance of 50 Ohm or a parallel arrangement of a chip external impedance and an on-chip integrated load impedance of 50 Ohm, and the connection between the photodiode down to the output pad is realized by a high-impedance transmission line having an impedance $\sqrt{(L/C)}$ distributed over its length, wherein for obtaining limit frequencies higher than 40 GHz the impedance ($Z_{leitung}$) of the high impedance transmission line distributed over the length is realized by a stray capacitance-loaded air bridge with distributed stray capacitance elements towards the substrate and the impedance distributed over the length of the air bridge is chosen at least as high as the effective load impedance being effective at the output pad and its length is varied by increasing the RC limitation so that the resulting -3dB total bandwidth is dominated by the physically limiting transit time limitation.

2. Method for optimizing a photodiode chip according to claim 1, **characterized in that** the impedance ($Z_{leitung}$) of the high impedance transmission line distributed over the length is chosen at least twice as high as the effective load impedance.

**Revendications**

1. Procédé d'optimisation d'une puce monolithique de photodiode pour sa fabrication, dans lequel une mésa de photodiode est établie par voie d'épitaxie, et une jonction de lignes à partir de la zone de photodiode active vers le plot de sortie d'une sortie haute fréquence de la puce de photodiode est réalisée, une impédance de charge effective agissant sur le plot de sortie est formée d'une impédance de charge de 50 ohms externe à la puce ou d'un circuit en parallèle composé de l'impédance de charge externe à la puce et d'une impédance de charge intégrée sur puce de 50 ohms, et la connexion descendant de la mésa de photodiode vers le plot de sortie est réalisée avec une ligne à valeur ohmique élevée avec l'impédance √(L/C) répartie sur sa longueur,

l'impédance ($Z_{leitung}$), répartie sur la longueur, de la ligne à valeur ohmique élevée étant, pour l'obtention de fréquences limites supérieures à 40 GHz, réalisée par un pont d'air qui est soumis à une capacité parasite intégrée sur la puce de photodiode, avec des éléments de capacité parasite répartis dirigés vers le substrat, et l'impédance du pont d'air répartie sur la longueur est choisie avec une valeur au moins égale à l'impédance de charge effective active sur le plot de sortie, et sa longueur est modifiée, avec une élévation de la limitation RC, de telle sorte que la largeur de bande totale de -3dB qui en résulte est dominée par la limitation de temps de transit limitante physiquement.

2. Procédé d'optimisation d'une puce de photodiode selon la revendication 1, **caractérisé en ce que** l'impédance ($Z_{leitung}$), répartie sur la longueur, de la ligne à valeur ohmique élevée est choisie avec une valeur au moins deux fois plus élevée que l'impédance de charge effective.

# Fig. 1

# Fig. 2a

# Fig. 2b

Fig. 3

Fig. 4

Fig. 5

Fig. 6

Fig. 7

Fig. 8

**IN DER BESCHREIBUNG AUFGEFÜHRTE DOKUMENTE**

**In der Beschreibung aufgeführte Patentdokumente**

- DE 10044521 A1

**In der Beschreibung aufgeführte Nicht-Patentliteratur**

- **KATO et al.** Design of Ultrawide-Band, High-Sensivity p-i-n Photodetectors. *IEICE Trans. Electron.,* Februar 1993, vol. E76-C (2), 214-221

- InP-Based Waveguide -Integrated Photodetector With 100-GHz Bandwidth. **BACH H-G et al.** IEEE Journal of Selected Topics in Quantum Electronics. IEEE Service Center, 01. Juli 2004, vol. 10, 668-672